(19) Europäisches Patentamt
European Patent Office
Office européen des brevets

(11) **EP 1 391 742 B1**

(12) **EUROPÄISCHE PATENTSCHRIFT**

(45) Veröffentlichungstag und Bekanntmachung des Hinweises auf die Patenterteilung:
**09.06.2010 Patentblatt 2010/23**

(51) Int Cl.:
***G01R 31/36*** *(2006.01)*

(21) Anmeldenummer: **03016380.2**

(22) Anmeldetag: **19.07.2003**

(54) **Überwachungseinrichtung und Verfahren zur Ermittlung des Betriebszustands einer Speicherbatterie**

Monitoring device and method for determining the operating state of a storage battery

Dispositif de surveillance et procédé de détermination de l'état de fonctionnement d'une batterie d'accumulateurs

(84) Benannte Vertragsstaaten:
**AT BE BG CH CY CZ DE DK EE ES FI FR GB GR HU IE IT LI LU MC NL PT RO SE SI SK TR**

(30) Priorität: **13.08.2002 DE 10236958**

(43) Veröffentlichungstag der Anmeldung:
**25.02.2004 Patentblatt 2004/09**

(73) Patentinhaber: **VB Autobatterie GmbH & Co. KGaA
30419 Hannover (DE)**

(72) Erfinder:
• **Laig-Hörstebrock, Helmut, Dr. Dipl.-Phys.
60320 Frankfurt (DE)**
• **Meissner, Eberhard, Dr. Dipl.-Phys.
31515 Wunstorf (DE)**

(74) Vertreter: **Lins, Edgar et al
GRAMM, LINS & PARTNER
Theodor-Heuss-Strasse 1
38122 Braunschweig (DE)**

(56) Entgegenhaltungen:
**US-A- 6 118 275**

**Beschreibung**

Die Erfindung betrifft ein Verfahren zur Ermittlung der entnehmbaren Ladungsmenge einer Speicherbatterie mit den Schritten:

- Ermitteln eines Antwortsignalverlaufes eines Antwortsignals der Speicherbatterie innerhalb eines Zeitintervalls auf eine elektrische Anregung der Speicherbatterie; und

- Linearisierung des Antwortsignalverlaufes

sowie eine Überwachungseinrichtung für eine Speicherbatterie mit Meßmitteln zur Messung von Batteriespannung und/oder Batterieströmen und mit Auswertemitteln.

Es besteht ein Bedarf, die entnehmbare Ladungsmenge einer Speicherbatterie während des Betriebs abzuschätzen.

Durch den Gebrauch von wiederaufladbaren Speicherbatterien, insbesondere beim Entlade- und Ladebetrieb, tritt ein Verschleiß ein. Daneben gibt es auch andere, den Verschleiß von elektrochemischen Energiespeicher beschleunigende Betriebsbedingungen. Dazu gehört z.B. beim Bleiakkumulator die gesamte Betriebsdauer, d.h. die gesamte seit der Inbetriebnahme verstrichene Zeit einschließlich der Perioden, in denen der Akkumulator nicht elektrisch beaufschlagt wurde. Dieser Verschleiß wird noch verstärkt durch erhöhte Temperaturen. Erhöhte Temperaturen können aber nicht nur den Verschleiß der Perioden ohne elektrischer Beaufschlagung beschleunigen, sondern durch zyklischen Entlade- und Ladebetrieb hervorgerufenen Verschleiß verstärken.

Bei einer Speicherbatterie drückt sich der Verschleiß u.a. in einer Minderung der Speicherfähigkeit für elektrische Ladung aus, so dass sich die entnehmbare Ladungsmenge ausgehend von dem Vollladezustand nicht einfach bestimmen lässt.

Die entnehmbare Ladungsmenge $Q_R$ der Speicherbatterie ist hierbei die Ladungsmenge, die ausgehend vom aktuellen Zustand der Speicherbatterie unter Nennbedingungen noch entnommen werden kann. Im Neuzustand der Speicherbatterie ist die Summe aus entnehmbarer Ladungsmenge und entladener Ladungsmenge die Speicherfähigkeit im Neuzustand.

Die Speicherfähigkeit im Neuzustand ist die tatsächliche Speicherfähigkeit eines neuwertigen, ungebrauchten Energiespeichers.

Die entladene Ladungsmenge ist die Ladungsmenge, die ausgehend vom vollgeladenen Zustand einer Speicherbatterie unter Nennbedingungen entnommen werden muss, um den aktuellen Ladezustand zu erreichen.

Als aktuelle Speicherfähigkeit ist die Ladungsmenge ausgedrückt in Ah definiert, die einem nach Vorschrift vollgeladenen Energiespeicher unter Nennbedingungen entnommen werden kann. Diese Größe ändert sich mit der Gebrauchsdauer im allgemeinen mit fallender Tendenz.

Als Nenn-Speicherfähigkeit ist der Nominalwert der Speicherfähigkeit definiert, den der Hersteller der Speicherbatterie angibt und der als Minderung der Speicherfähigkeit, d. h. als Differenz zwischen aktueller Speicherfähigkeit und Speicherfähigkeit im Neuzustand, verstanden wird.

Hierzu ist in dem US-Patent 5,761,072 ein Verfahren zur Bestimmung der Kapazität einer Speicherbatterie beschrieben, bei dem durch ein Filter ein schneller Strom und durch Mittelwertbildung mittels Integration ein langsamer Strom ermittelt wird. Die Werte für den schnellen und langsamen Strom werden in eine sogenannte Peukert-Beziehung eingesetzt, um eine Kapazität für einen schnellen Strom und für einen langsamen Strom zu ermitteln. Diese Kapazitäten werden gewichtet und hieraus eine Gesamtkapazität berechnet.

In der DE 93 21 638 wird ein elektronischer Batterietester zum Testen einer elektrochemischen Zelle oder Batterie beschrieben, die einen dynamischen Parameter, wie z.B. einen Leitwert oder einen Widerstand, aufweist. Der Batterietester hat eine Einrichtung zum Messen dieses dynamischen Parameters, zur Messung der Leerlaufspannung und zur Korrektur des gemessenen dynamischen Parameterwertes in bezug auf den Ladungszustand durch Anpassung an die Leerlaufspannung.

In dem US-Patent 5,680,050 ist ein Verfahren zur Batteriezustandserkennung offenbart, bei dem ein Korrekturwert basierend auf einem durchschnittlichen Entladestrom für einen Zeitraum bestimmt wird, der größer als der Zeitraum ist, der die Entladepolarisation in einen stationären Zustand bringt. Die Kapazität der Batterie im vollgeladenen Zustand wird mit diesem Korrekturwert multipliziert und der Energieverbrauch der Batterie wird von der verfügbaren Entladekapazität zur Bestimmung einer verfügbaren Reservekapazität substrahiert.

Die vorgenannten Verfahren und Vorrichtungen ermitteln aktuelle elektrische Kenngrößen einer Speicherbatterie hinsichtlich eines Leitwertes bzw. Innenwiderstands oder bestimmen die entnehmbare Entladekapazität einer Speicherbatterie in Abhängigkeit von dem Entladestrom, wobei nachteilig die Kapazität der vollgeladenen Speicherbatterie bekannt sein muss.

In der DE 691 31 276 T2 ist ein elektronischer Tester zur Bewertung der prozentualen Energiekapazität einer Speicherbatterie oder eine Batteriezelle offenbart. In diesem Verfahren wird der dynamische Leitwert bestimmt und zu einem Referenzleitwert ins Verhältnis gesetzt, der dem dynamischen Leitwert einer Batterie oder Batteriezelle mit 100 % Kapazität entspricht. Mit diesem Tester kann jedoch nicht die Gesamtkapazität einer vollgeladenen Speicherbatterie bestimmt und unterschieden werden, ob eine Änderung der Kapazität durch Alterung oder durch normale Entladung erfolgt ist. Es können noch nicht aus dem zeitlichen Gang der Meßwerte über einen längeren Zeitraum Informationen auf den Verschleißzustand der Speicherbatterie gewonnen werden. Als Maß für einen Batterieverschleiß ist der dynamische Leitwert zudem nur begrenzt aussagekräftig.

In der EP 0 516 336 B1 ist ein Verfahren zur Ermittlung der entnehmbaren Ladungsmenge bzw. Restkapazität einer Speicherbatterie beschrieben, bei dem im Impedanzspektrenraum der Imaginärteil eines Antwortsignalverlaufs als Funktion der Wurzel einer sinusförmigen Anregungsfrequenz betrachtet wird. Es erfolgt eine Extrapolation auf den Schnittpunkt des Antwortsignalverlaufs im Impedanzspektrenraum mit der Imaginärachse. Aus dem sich hieraus ergebenen Extrapolationswert wird auf die Restkapazität geschlossen. Dabei wird der Hochfrequenzschnittpunkt einer Warburg-Geraden gesucht und als Maß für die entnehmbare Ladungsmenge herangezogen.

US 6,118,275 A offenbart ein Verfahren zur Messung der Batteriekapazität in Abhängigkeit von einem Spannungsantwortsignal einer Batterie, basierend auf einem pulsförmigem Strom. Das Antwortsignal wird mit Hilfe eines Batteriemodells analysiert, um die Batteriekapazität als Korrelation zwischen einer gemessenen Batteriekapazität und Modellparametern zu ermitteln. Hierzu wird aus der Steigung und dem Schnittpunkt der y-Achse der durch lineare Approximation der Spannungsantwort ermittelten Geraden ein Begrenzungswiderstand und eine Begrenzungskapazität berechnet. Aus durch Analyse für spezifische Batterien gewonnenen Werten wird die Batteriekapazität dann in Abhängigkeit von dem Begrenzungswiderstand und der Begrenzungskapazität, beispielsweise durch Auswertung einer Tabelle, ermittelt.

Aufgabe der Erfindung ist es daher, ein verbessertes Verfahren zur Bestimmung der einer Speicherbatterie noch entnehmbaren Ladungsmenge zu schaffen, wenn diese Speicherbatterie nicht mehr im Neuzustand ist.

Die Aufgabe wird erfindungsgemäß gelöst durch Bestimmen der entnehmbaren Ladungsmenge in Abhängigkeit von dem Änderungsgrad des linearisierten Antwortsignalverlaufes in dem Zeitintervall.

Es wurde erkannt, dass sich die entnehmbare Ladungsmenge aus einem Antwortsignal auf eine Anregung der Speicherbatterie ermittelt werden kann, wenn das Antwortsignal linearisiert wird. Dabei wurde überraschend gefunden, dass der Änderungsgrad eines solchen linearisierten Antwortsignalverlaufes unmittelbar als Maß für die entnehmbare Ladungsmenge eingesetzt werden kann.

Eine solche Anregung kann beispielsweise durch Aufprägen von Strom- und/oder Spannungspulsen erfolgen. Gleichermaßen können Antwortsignalverläufe auf Anregungen zur Ermittlung der entnehmbaren Ladungsmenge herangezogen werden, die sich im Betrieb durch geeignete Belastung der Speicherbatterie ergeben.

Mit dem Verfahren ist es nunmehr auf einfache Weise möglich, eine Speicherbatterie zu überwachen und die entnehmbare Ladungsmenge zu ermitteln, da lediglich Antwortsignalverläufe aufgezeichnet und rechnerisch ausgewertet werden müssen.

Der Antwortsignalverlauf ist vorzugsweise eine Spannungsantwort auf eine pulsförmige Stromanregung der Speicherbatterie, kann jedoch auch eine Stromantwort auf eine pulsförmige Spannungserregung sein.

Der Änderungsgrad ergibt sich vorzugsweise durch Ermitteln der Steigung einer Ausgleichsgeraden durch den linearisierten Antwortsignalverlauf. Eine solche Ausgleichsgerade kann auf einfache Weise für eine Folge von Meßwerten in den betrachteten Zeitintervallen ermittelt werden.

Aus der Steigung ergibt sich die entnehmbare Ladungsmenge vorzugsweise umgekehrt proportional zur Steigung der Ausgleichsgeraden, wobei zusätzlich ein Proportionalitätsfaktor berücksichtigt werden kann, der beispielsweise die Energiespeicherfähigkeit $K_{neu}$ der Speicherbatterie im Neuzustand ist.

Besonders vorteilhaft ist es, zur Linearisierung des Antwortsignalverlaufes den Antwortsignalverlauf als Funktion der Quadratwurzel aus der Zeitdifferenz zwischen der Anfangszeit des betrachteten Zeitintervalls und der Zeit vorzunehmen.

Weiterhin ist es vorteilhaft, die Meßgenauigkeit durch Beaufschlagen der Speicherbatterie mit einer Folge von Strom- oder Spannungspulsen zur Anregung zu erhöhen, wobei die Änderungsgrade für die Antwortsignalverläufe der einzelnen Strom- oder Spannungspulse und die entnehmbare Ladungsmenge in Abhängigkeit der gemittelten Änderungsgrade bestimmt wird.

Besonders vorteilhaft ist es, die Änderungsgrade der linearisierten Antwortsignalverläufe während der Gebrauchsdauer der Speicherbatterie wiederholt zu bestimmen und aus der relativen Veränderung der Änderungsgrade die relative Veränderung der entnehmbaren Ladungsmenge zu bestimmen. Die relative Veränderung der entnehmbaren Ladungsmenge kann dann ein Maß für den Verschleiß der Speicherbatterie sein.

Weiterhin ist es vorteilhaft, den Änderungsgrad auf einen für die Speicherbatterie Neuzustand charakteristischen Änderungsgradkennwert zu beziehen und aus dem Quotienten die entnehmbare Ladungsmenge zu bestimmen. Dabei kann die entnehmbare Ladungsmenge als Funktion der aktuellen Energiespeicherfähigkeit bestimmt werden, die proportional zum Verhältnis des charakteristischen Änderungsgradkennwertes im Neuzustand der Speicherbatterie zu einer ermittelten Steigung eines linearisierten Antwortsignalverlaufes ist. Der charakteristische Änderungsgradkennwert kann bei einer neuwertigen Speicherbatterie in einem definierten Betriebszeitraum oder Zeitraum nach Inbetriebnahme angelernt werden, indem die Änderungsgrade in dieser definierten Zeit nach dem oben genannten Verfahren wiederholt bestimmt werden.

Die aktuelle Energiespeicherfähigkeit wird vorzugsweise nach der Formel

$$K = K_{neu} * S_{neu} / S$$

bestimmt, wobei $K_{neu}$ die Speicherfähigkeit der Speicherbatterie im Neuzustand, $S_{neu}$ der charakteristische Änderungsgradkennwert und S der aktuelle Änderungsgrad ist.

Die Änderungsgrade werden zudem vorzugsweise bei vergleichbaren Ladezuständen und Temperaturen der Speicherbatterie bestimmt, so dass diese Randbedingungen für verschiedene aufeinanderfolgende Messungen ähnlich sind.

Die entnehmbare Ladungsmenge wird zudem vorzugsweise aus dem Änderungsgrad mittels einer Funktion oder Wertetabelle bestimmt, wobei zusätzlich eine Abhängigkeit von der Temperatur der Speicherbatterie vorgesehen sein kann. Dabei werden die Änderungsgrade bevorzugt auf eine Nenntemperatur normiert.

Die Anregung der Speicherbatterie erfolgt bevorzugt mit einem Betrag der Stromwerte der Stromanregung, der höchstens dem 10-stündigen, vorzugsweise höchstens dem 50-stündigen und besonders vorzugsweise höchstens dem 200-stündigen Strom entspricht.

Weiterhin ist es vorteilhaft, wenn eine Stromänderung der Stromanregung mit einer Stromänderungsrate erfolgt, die in ihrem Betrag mindestens in der Größenordnung des Quotienten des 5000-stündigen Stroms pro Sekunde, vorzugsweise mindestens in der Größenordnung des Quotienten des 1000-stündigen Stroms pro Sekunde und besonders vorzugsweise mindestens in der Größenordnung des Quotienten des 200-stündigen Stroms pro Sekunde liegt.

Zur Bestimmung des Änderungsgrades wird vorteilhafter Weise nur der Abschnitt des Antwortsignalverlaufs herangezogen, der frühestens 1 Sekunde, vorzugsweise 10 Sekunden, und spätestens 1000 Sekunden, vorzugsweise 100 Sekunden nach der Anregung gemessen wurde. Zudem sollten nur solche Werte des Antwortsignalverlaufs zu Linearisierung herangezogen werden, die ein definiertes Bestimmtheitsmaß (R-Faktor) erfüllen und sich damit zur Anpassung an einen linearen Zusammenhang eignen.

Besonders vorteilhaft ist es, wenn die ermittelte entnehmbare Ladungsmenge mit einem aktuellen Entladegrad und/oder einem aktuellen Ladezustand verknüpft wird, um die in die Speicherbatterie einladbare Ladungsmenge zu ermitteln. Weiterhin kann die ermittelte entnehmbare Ladungsmenge, der Änderungsgrad, die einladbare Ladungsmenge und/oder die Energiespeicherfähigkeit der Speicherbatterie als Vergleichsgröße mit einem definierten Schwellwert verglichen werden, wobei die Abweichung oder das Verhältnis der Vergleichsgröße mit dem Schwellwert ausgegeben und gegebenenfalls zur weiteren Verarbeitung verwendet oder angezeigt wird. Der Schwellwert ist vorzugsweise temperaturabhängig gewählt.

Ein Maß für die Minderung der Speicherfähigkeit kann vorzugsweise ermittelt werden, indem die aktuelle Speicherfähigkeit der Speicherbatterie aus der ermittelten entnehmbaren Ladungsmenge bestimmt und die aktuelle Speicherfähigkeit mit der Speicherfähigkeit der Speicherbatterie im Neuzustand verknüpft wird. Das ermittelte Maß für die Minderung der Speicherfähigkeit wird dann vorzugsweise mit einem definierten Schwellwert verglichen.

Die Aufgabe wird weiterhin durch eine Überwachungseinrichtung gelöst, die zur Durchführung des oben beschriebenen Verfahrens ausgebildete Auswertemittel hat. Diese Auswertemittel können beispielsweise als auf einem Prozessor ausführbares Programm ausgestaltet sein.

Die Erfindung wird nachfolgend anhand der beigefügten Zeichnungen näher erläutert. Es zeigen:

Figur 1 - Diagramm des Spannungsverlaufs einer Speicherbatterie bei Aufprägen eines Strompulses;

Figur 2 - Diagramm linearisierter Antwortsignalverläufe für Batterien mit unterschiedlichen Speicherfähigkeiten;

Figur 3 - Diagramm eines Spannungsantwortsignalverlaufs auf einen galvanischen Doppelstrompuls.

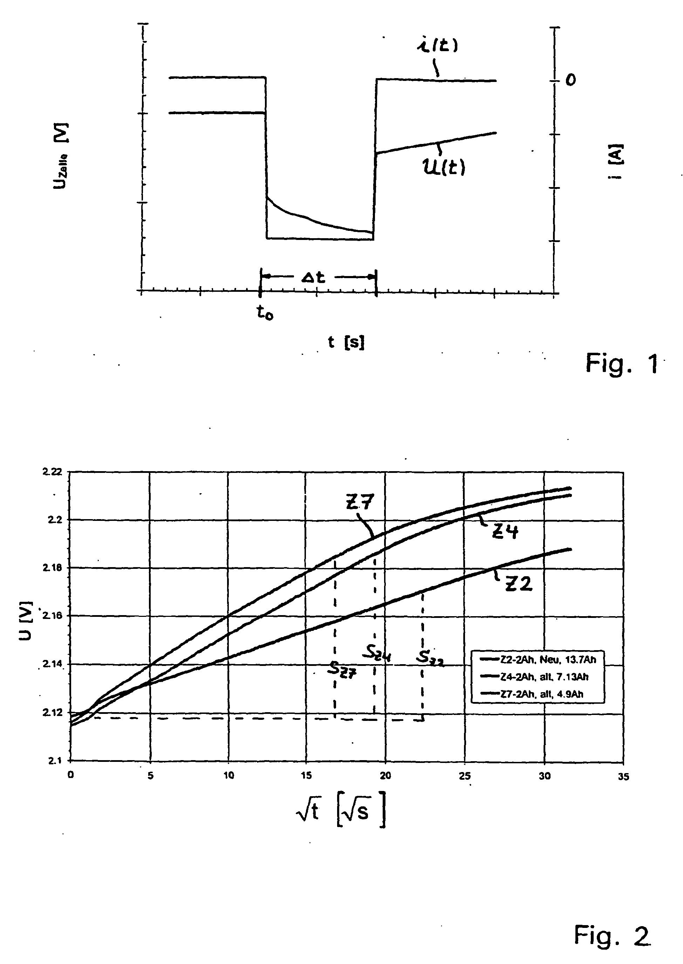

Die Figur 1 lässt ein Diagramm eines Spannungs-Antwortsignalverlaufs als Funktion der Zeit t auf einen rechteckförmigen Strompuls i(t) erkennen, der auf eine Speicherbatterie aufgeprägt wurde. Die Anfangszeit $t_0$ des rechteckförmigen Strompulses i(t) legt das betrachtete Zeitintervall $\Delta t$ bis zum Abklingen des Antwortsignals U(t) fest.

Der Betrag des aufgeprägten Strompulses i(t) sollte relativ klein sein, beispielsweise kleiner als der 10-stündige Strom der Speicherbatterie.

Die Messwerte des Antwortsignalverlaufs U(t) in dem betrachteten Zeitintervall $\Delta t$ werden dann, wie beispielsweise in der Figur 2 skizziert, linearisiert, indem sie gegen die Quadratwurzel aus der Zeitdifferenz $\Delta t = t - t_0$ aufgetragen werden $\left( U = f\left(\sqrt{t - t_0}\right)\right)$. Es ist aber denkbar, andere Linearisierungsverfahren einzusetzen.

Durch die Meßwertepaare eines derartig linearisierten Antwortsignalverlaufs wird eine ausgleichende Gerade mit Hilfe bekannter Ausgleichsverfahren gelegt und die Steigung dieser Geraden als Änderungsgrad S bestimmt. Der Änderungsgrad S ist ein Kennwert für die Ladungsmenge $Q_R$, die der Speicherbatterie aktuell noch entnehmbar ist.

Das betrachtete Zeitintervall $\Delta t$ ist vorzugsweise so gewählt, dass das Zeitintervall $\Delta t = t - t_0$ größer 1

Sekunde, vorzugsweise 10 Sekunden ist, jedoch nicht länger als 100 Sekunden, vorzugsweise nicht länger als 200 Sekunden ist.

Wenn die Messung des Änderungsgrades S im Vollladezustand der Speicherbatterie erfolgt, ist der Änderungsgrad S ein Kennwert für die aktuelle Speicherfähigkeit, d.h. der Ladungsmenge in Ah, die einer nach Vorschrift vollgeladenen Speicherbatterie unter Nennbedingungen entnommen werden kann.

Die Steigung bzw. der Änderungsgrad S verhält sich umgekehrt proportional zur aktuell entnehmbaren Ladungsmenge $Q_R$ und steigt somit bei mit der Gebrauchsdauer nachlassender Speicherfähigkeit an. Der Änderungsgrad S ist somit auch ein Maß für den Verschleiß der Speicherbatterie bzw. des Verlusts an Speicherfähigkeit.

Dieser Zusammenhang ist in der Figur 2 deutlich zu erkennen, die drei linearisierte Antwortsignalverläufe für drei Speicherbatterien mit unterschiedlichem Alterungsgrad zeigen. Der Antwortsignalverlauf Z2 mit der geringsten Steigung wurde bei einer neuwertigen Speicherbatterie mit einer verfügbaren Speicherkapazität von 13,7Ah gemessen. Der Antwortsignalverlauf Z4 wurde bei einer gealterten Speicherbatterie mit einer noch verfügbaren Speicherkapazität von 7,13Ah gemessen und weist eine im Vergleich zum Antwortsignalverlauf einer neuwertigen Speicherbatterie größere Steigung $S_i$ auf. Es ist erkennbar, dass der Antwortsignalverlauf Z7 ein noch größere Steilheit als die vorigen beiden Antwortsignalverläufe Z2, Z4 hat. Dieser Antwortsignalverlauf Z7 wurde bei einer gealterten Speicherbatterie mit einer verfügbaren Speicherkapazität von 4,9Ah gemessen.

Die zu untersuchende Speicherbatterie kann gleichermaßen nicht nur mit einem einzigen aufgeprägten Strompuls i(t), sondern mit einer Folge von rechteckförmigen Strompulsen i(t) mit gleicher oder unterschiedlicher Stromstärke beaufschlagt werden. Wiederum wird die Spannungsantwort U (t) auf die Strompulse i(t) als Funktion der Zeit t für jeden Strompuls i(t) registriert. Die Zeit t beginnend vom Augenblick des jeweiligen Strompulses mit der Anfangszeit $t_0$ wird ebenfalls registriert und die Messwerte der Spannungsantwort auf die Strompulse i(t) als Funktion der Zeit U(t) für jeden Strompuls i(t) gegen die Quadratwurzel aus der Zeitdifferenz $\Delta t = t - t_0$ aufgetragen. Dabei wird, wie oben beschrieben, durch Ausgleichsverfahren jeweils eine Gerade bestimmt und die Steigung $S_i$ der Geraden ermittelt. Der Änderungsgrad S wird aus den gemittelten Steigungen $S_i$ ermittelt und zur Bestimmung der entnehmbaren Ladungsmenge $Q_R$ bzw. des Verlusts an Speicherfähigkeit eingesetzt. Der Änderungsgrad S kann sich hierbei aus dem arithmetischen Mittel der Steigungen $S_i$, dem Medianwert oder ähnlichem berechnen.

Weiterhin ist es vorteilhaft, mit vielen Messungen im Verlauf der Gebrauchsdauer der Speicherbatterie eine Vielzahl von Steigungen $S_i$ bzw. Änderungsgrade zu bestimmen. Aus dem Trend der Änderungsgrade S, d.h. der relativen Veränderung der Änderungsgrade S, kann die relative Änderung der entnehmbaren Ladungsmenge $Q_R$ bestimmt werden. Aus dieser Veränderung kann auf den Verschleiß der Speicherbatterie, insbesondere auf das Nachlassen der speicherbaren Ladungsmenge geschlossen werden.

Hierzu wird vorzugsweise bei einer neuwertigen Speicherbatterie mit dem oben beschriebenen Verfahren ein für diesen Zustand mit neuwertiger Energiespeicherfähigkeit $K_{neu}$ charakteristischer Änderungsgrad $S_{neu}$ bestimmt. Nach einer bestimmten Lernphase, deren Ende z.B. durch das Verstreichen einer gewissen Anzahl von Betriebsstunden oder einer bestimmten Zeit nach Inbetriebnahme des Energiespeicher gegeben sein kann, wird das Anlernen des für die neuwertige Speicherbatterie charakteristischen Änderungsgrades $S_{neu}$ beendet. Die später bestimmten Änderungsgrade S werden dann mit dem charakteristischen Änderungsgradkennwertes $S_{neu}$ verglichen und eine aktuelle Energiespeicherfähigkeit K aus dem Verhältnis des aktuellen Änderungsgrades S zu dem charakteristischen Änderungsgradkennwert $S_{neu}$ bestimmt:

$$K = K_{neu} * f(S / S_{neu}).$$

Beispielsweise kann die aktuelle Energiespeicherfähigkeit K relativ einfach unmittelbar durch die Gleichung

$$K = K_{neu} * S_{neu} / S$$

bestimmt werden, wobei $K_{neu}$ die Energiespeicherfähigkeit $K_{neu}$ der Speicherbatterie im Neuzustand, d.h. die Nennspeicherkapazität ist.

Anstelle einer Vielzahl einzelner Strompulse i (t) kann auch ein galvanischer Doppelpuls mit Vorzeichenwechsel des Stromflusses zur Ermittlung eines Änderungsgrades S eingesetzt werden.

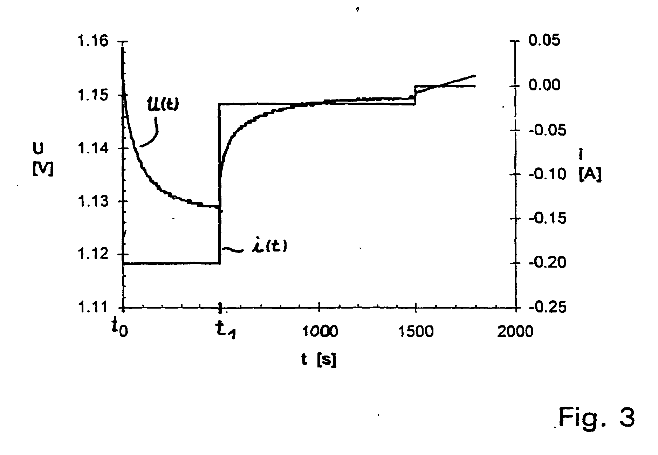

Die Figur 3 lässt ein Diagramm eines Spannungs-Antwortsignalverlaufes auf einen galvanostatischen Doppelstromimpuls zur Anregung der Speicherbatterie erkennen. Anstelle einer Vielzahl einzelner Strompulse i(t) kann auch ein galvanischer Doppelpuls i (t) mit Vorzeichenwechsel des Stromflusses zur Ermittlung des Änderungsgrades S eingesetzt werden. Dieses Verfahren hat den Vorteil, dass der Netto-Ladezustand unverändert bleibt und zur Anregung der Speicherbatterie insgesamt weniger Energie benötigt wird, wenn die in der Entlade-Halbwelle der Speicherbatterie entnommene Energiemenge in der Lade-Halbwelle genutzt wird.

Die skizzierten Antwortsignalverläufe in den beiden Zeitintervallen $\Delta t_1$ und $\Delta t_2$ des Doppelstrompulses werden jeweils linearisiert und hieraus die Steigungen $S_i$ ermittelt, wobei aus den gemittelten Steigungen S; der Änderungsgrad S berechnet wird.

Die Anregung der Speicherbatterie erfolgt vorzugsweise gesteuert durch ein Steuergerät durch Aufprägen eines Stromprofils i(t) mit weitgehend rechteckigen Flanken, wie in den Figuren 1 und 3 erkennbar ist. Dies geschieht vorzugsweise in Betriebsphasen, während denen sonst keine oder jedenfalls nur eine geringe elektrische Belastung durch andere Komponenten erfolgt. Bei einem Kraftfahrzeug ist dies beispielsweise eine Standphase, in der üblicherweise eine Ruhestrombelastung in Entladerichtung von ca. 10 bis 100 mA vorliegt, die auch bei Fahrzeugruhe betriebene Verbraucher verursacht ist. Das Steuergerät kann das Stromprofil i(t) selbst erzeugen. Es ist aber auch denkbar, dass andere Stromverbraucher oder Stromquellen in solcher Weise angesteuert werden, dass sich für die Speicherbatterie das gewünschte Stromprofil i(t) ergibt. Beispielsweise kann auch ein weiterer Energiespeicher als Stromverbraucher und/oder als Stromquelle gegebenenfalls gekoppelt über einen Dc-Dc-Wandler zur Anregung der Speicherbatterie eingesetzt werden.

Anstelle eines rechteckigen Stromprofiles i(t) kann auch ein anders geformtes Stromprofil beispielsweise mit einem F-Transformator aufgeprägt werden. Ebenso kann anstelle eines Stromprofils i(t) ein Spannungsprofil U(t) beispielsweise mit einem F-Transformator aufgeprägt und die Spannungsantwort ausgewertet werden.

Weiterhin ist es möglich, anstelle der beschriebenen Auswertung der Steigung $S_i$ des Antwortsignalverlaufs im Zeitraum die Steigung $S_i$ des Antwortsignalverlaufs im Impedanzraum zu bestimmen. Hierzu wird die Steigung $S_i$ der Warburg-Geraden Z über der Quadratwurzel der Frequenz betrachtet. Im Unterschied zu dem in der EP 0 516 336 B1 beschriebenen Verfahren wird somit die Steigung der Warburg-Geraden und nicht der Hochfrequenzschnittpunkt gesucht und ausgewertet. Die Anregung der Speicherbatterie erfolgt dabei jedoch wie in der EP 0 516 336 B1 beschriebenen Verfahren.

**Patentansprüche**

1. Verfahren zur Ermittlung der entnehmbaren Ladungsmenge ($Q_R$) einer Speicherbatterie mit den Schritten:

   - Elektrische Anregung der Speicherbatterie,
   - Ermitteln eines zeitlichen Antwortsignalverlaufs eines Antwortsignals der Speicherbatterie innerhalb eines Zeitintervalls auf die elektrische Anregung,
   - Linearisierung des Antwortsignalverlaufes,
   - Bestimmen des Änderungsgrades (S) des linearisierten Antwortsignalverlaufes in dem Zeitintervall,
   - Bestimmen der entnehmbaren Ladungsmenge ($Q_R$) unmittelbar aus dem Änderungsgrad (S).

2. Verfahren nach Anspruch 1, **dadurch gekennzeichnet, dass** der Antwortsignalverlauf eine Spannungsantwort (M (t)) auf eine pulsförmige Stromanregung (I (t)) der Speicherbatterie ist.

3. Verfahren nach Anspruch 1, **dadurch gekennzeichnet, dass** der Antwortsignalverlauf eine Stromantwort (I (t)) auf eine pulsförmige Spannungserregung (U (t)) der Speicherbatterie ist.

4. Verfahren nach einem der vorhergehenden Ansprüche, **gekennzeichnet durch**

   - Bestimmen einer Ausgleichsgeraden **durch** den linearisierten Antwortsignalverlauf und
   - Ermitteln der Steigung ($S_i$) der Ausgleichsgeraden als Änderungsgrad.

5. Verfahren nach Anspruch 4, **dadurch gekennzeichnet, dass** die entnehmbare Ladungsmenge ($Q_R$) umgekehrt proportional zur Steigung ($S_i$) der Ausgleichsgeraden ist.

6. Verfahren nach einem der vorhergehenden Ansprüche, **dadurch gekennzeichnet, dass** die Linearisierung des Antwortsignalverlaufes durch Auswerten des Antwortsignalverlaufes als Funktion der Quadratwurzel aus der Zeitdifferenz ($t-t_0$) zwischen der Anfangszeit ($t_0$) des Zeitintervalls ($\Delta t$) und der Zeit (t) erfolgt.

7. Verfahren nach einem der vorhergehenden Ansprüche, **gekennzeichnet durch**

   - Beaufschlagen der Speicherbatterie mit einer Folge von Strom- oder Spannungspulsen,
   - Bestimmen der Änderungsgrade (S) jeweils für die Antwortsignalverläufe der einzelnen Strom- oder Spannungspulse,
   - Bestimmen der entnehmbaren Ladungsmenge ($Q_R$) in Abhängigkeit der ermittelten Änderungsgrade (S).

8. Verfahren nach einem der vorhergehenden Ansprüche, **gekennzeichnet durch**

   - wiederholtes Bestimmen der Änderungsgrade (S) der linearisierten Antwortsignalverläufe während der Gebrauchsdauer der Speicherbatterie,
   - Bestimmen der relativen Veränderung der entnehmbaren Ladungsmenge ($Q_R$) in Abhängigkeit von der relativen Veränderung der Änderungsgrade (S), und
   - Bestimmen eines Maßes für den Verschleiß der Speicherbatterie aus der relativen Veränderung.

9. Verfahren nach einem der vorhergehenden Ansprüche, **gekennzeichnet durch** Bestimmen der entnehmbaren Ladungsmenge ($Q_R$) in Abhängigkeit von dem auf einen für die Speicherbatterie im Neuzustand charakteristischen Änderungsgradkennwert ($S_{neu}$) bezogenen Änderungsgrad (S).

10. Verfahren nach Anspruch 9, **dadurch gekennzeichnet, dass** die entnehmbare Ladungsmenge ($Q_R$) als Funktion der aktuellen Energiespeicherfähigkeit (K) bestimmt wird, wobei die aktuelle Energiespeicherfähigkeit (K) proportional zu dem Verhältnis des charakteristischen Änderungsgradkennwertes ($S_{neu}$) im Neuzustand der Speicherbatterie zu einer ermittelten Steigung ($S_i$) eines linearisierten Antwortsignalverlaufes ist.

11. Verfahren nach einem Anspruch 10, **gekennzeichnet durch** Bestimmen der aktuellen Energiespeicherfähigkeit (K) als Maß für die entnehmbare Ladungsmenge ($Q_R$) nach der Formel:

$$K = K_{neu} * S_{neu} / S,$$

wobei $K_{neu}$ die Speicherfähigkeit der Speicherbatterie im Neuzustand, $S_{neu}$ der charakteristische Änderungsgradkennwert und S der aktuelle Änderungsgrad ist.

12. Verfahren nach einem der Ansprüche 9 bis 11, **gekennzeichnet durch** wiederholtes Bestimmen von Änderungsgraden (S) für eine neuwertige Speicherbatterie über eine definierte Zeit und Anlernen eines charakteristischen Änderungsgradkennwertes ($S_{neu}$) aus den bestimmten Änderungsgraden (S).

13. Verfahren nach einem der vorhergehenden Ansprüche, **gekennzeichnet durch** Bestimmen der Änderungsgrade (S) bei vergleichbaren Ladezuständen und Temperaturen der Speicherbatterie.

14. Verfahren nach einem der vorhergehenden Ansprüche, **gekennzeichnet durch** Bestimmen der entnehmbaren Ladungsmenge ($Q_R$) aus dem Änderungsgrad (S) mittels einer Funktion oder einer Wertetabelle.

15. Verfahren nach einem der vorhergehenden Ansprüche, **gekennzeichnet durch** Bestimmen der entnehmbaren Ladungsmenge ($Q_R$) in Abhängigkeit von der Temperatur (T) der Speicherbatterie.

16. Verfahren nach Anspruch 15, **gekennzeichnet durch** Normieren der Änderungsgrade (S) auf eine Nenntemperatur ($T_n$).

17. Verfahren nach einem der vorhergehenden Ansprüche, **dadurch gekennzeichnet, dass** der Betrag der Stromwerte (I) der Stromanregung höchstens dem 10-stündigen, vorzugsweise höchstens dem 50-stündigen und besonders vorzugsweise dem 200-stündigen Strom entspricht.

18. Verfahren nach einem der vorhergehenden Ansprüche, **dadurch gekennzeichnet, dass** eine Stromänderung der Stromanregung mit einer Stromänderungsrate (dI/Dt) erfolgt, die in ihrem Betrag mindestens in der Größenordnung des Quotienten des 5000-stündigen Stroms pro Sekunde, vorzugsweise mindestens in der Größenordnung des Quotienten des 1000-stündigen Stroms pro Sekunde und besonders vorzugsweise mindestens in der Größenordnung des Quotienten des 200-stündigen Stroms pro Sekunde liegt.

19. Verfahren nach einem der vorhergehenden Ansprüche, **dadurch gekennzeichnet, dass** der Änderungsgrad (S) nur aus dem Abschnitt des Antwortsignalverlaufs bestimmt wird, der frühestens eine Sekunde, vorzugsweise 10 Sekunden und spätestens 1000 Sekunden und vorzugsweise spätestens 100 Sekunden nach der Anregung gemessen wurde.

20. Verfahren nach einem der vorhergehenden Ansprüche, **dadurch gekennzeichnet, dass** nur solche Werte des Antwortsignalverlaufs zur Linearisierung herangezogen werden, die ein definiertes Bestimmtheitsmaß erfüllen.

21. Verfahren nach einem der vorhergehenden Ansprüche, **gekennzeichnet durch** Aufprägen einer pulsförmigen Stromanregung (I (t)) **durch** eine elektrische Schalteinheit auf die Speicherbatterle.

22. Verfahren nach einem der vorhergehenden Ansprüche, **gekennzeichnet durch** Verknüpfen der ermittelten entnehmbaren Ladungsmenge ($Q_R$) mit einem aktuellen Entladegrad (DoD) und/oder eines aktuellen Ladezustandes (SoC) zur Ermittlung der in die Speicherbatterie einladbare Ladungsmenge ($Q_L$).

23. Verfahren nach einem der vorhergehenden Ansprüche, **gekennzeichnet durch** Vergleich der ermittelten entnehmbaren Ladungsmenge ($Q_R$), des Änderungsgrades (S), der einladbaren Ladungsmenge ($Q_L$) und/oder der Energiespeicherfähigkeit (K) der Speicherbatterie als Vergleichsgröße mit einem definierten Schwellwert und Ausgeben der Abweichung oder des Verhältnisses der Vergleichsgröße mit dem Schwellwert.

**24.** Verfahren nach Anspruch 23, **dadurch gekennzeichnet, dass** der Schwellwert temperaturabhängig ist.

**25.** Verfahren nach einem der vorhergehenden Ansprüche, **gekennzeichnet durch** Bestimmen der aktuellen Spelcherfähigkelt der Speicherbatterie aus der ermittelten entnehmbaren Ladungsmenge ($Q_R$) und Verknüpfen der aktuellen Speicherfähigkeit mit der Speicherfähigkeit der Speicherbatterie im Neuzustand zur Ermittlung eines Maß für die Minderung der Speicherfähigkeit.

**26.** Verfahren nach Anspruch 25, **gekennzeichnet durch** Vergleichen des ermittelten Maßes für die Minderung der Speicherfähigkeit mit einem definierten Schwellwert.

**27.** Überwachungseinrichtung für eine Speicherbatterie mit Meßmitteln zur Messung von Batteriespannung ($U(t)$) und/oder Batterieströmen ($I(t)$ über Zeitintervalle ($\Delta t$) und mit Auswertemitteln, **dadurch gekennzeichnet, dass** die Auswertemittel zur Durchführung des Verfahrens nach einem der vorhergehenden Ansprüche ausgebildet sind.

**Claims**

**1.** Method for determining the amount of charge ($Q_R$) which can be drawn from a storage battery, **characterized by**

- Electrical stimulation of the storage battery,
- Determining a temporal response signal profile of a response signal of the storage battery within a time interval to the electrical stimulation,
- the response signal profile being linearized;
- the degree of change (S) of the linearized response signal profile in the time interval being determined;
- the amount of charge ($Q_R$) which can be drawn being determined directly as a function of the degree of change (S).

**2.** Method according to Claim 1, **characterized in that** the response signal profile is a voltage response ($U(t)$) to a pulsed current stimulus ($I(t)$) to the storage battery.

**3.** Method according to Claim 1, **characterized in that** the response signal profile is a current response ($I(t)$) to a pulsed voltage stimulus ($u(t)$) to the storage battery.

**4.** Method according to one of the preceding claims, **characterized by**

- a regression straight line being determined by the linearized response signal profile, and
- the gradient (Si) of the regression straight line being determined as the degree of change.

**5.** Method according to Claim 4, **characterized in that** the amount of charge ($Q_R$) which can be drawn is inversely proportional to the gradient (Si) of the regression straight line.

**6.** The method as claimed in one of the preceding claims, **characterized in that** the linearization of the response signal profile is carried out by evaluation of the response signal profile as a function of the square root of the time difference ($t-t_o$) between the start time (to) of the time interval ($\Delta t$) and the time (t).

**7.** Method according to one of the preceding claims, **characterized by**

- a sequence of current pulses or voltage pulses being applied to the storage battery,
- the degrees of change (S) being determined for each of the response signal profiles of the individual current pulses or voltage pulses,
- the amount of charge (QR) which can be drawn being determined as a function of the determined degrees of change (S).

**8.** Method according to one of the preceding claims, **characterized by**

- the degrees of change (S) of the linearized response signal profiles being determined repeatedly throughout the time during which the storage battery is in use,
- the relative change in the amount of charge (QR) which can be drawn being determined as a function of the relative change in the degrees of change (S), and
- a measure for the wear to the storage battery being determined from the relative change.

**9.** Method according to one of the preceding claims, **characterized by** the amount of charge (QR) which can be drawn being determined as a function of the degree of change (S) related to a degree of change characteristic value ($S_{neu}$) which is characteristic of the storage battery in the new state.

**10.** Method according to claim 9, **characterized in that** the amount of charge ($Q_R$) which can be drawn being determined as a function of the present energy storage capacity (K), with the present energy storage capacity (K) being proportional to the ratio of the degree of change characteristic value ($S_{neu}$) of the storage battery in the new state to the determined gradient ($S_i$) of a linearized response signal profile.

**11.** Method according to Claim 10, **characterized in that** the present energy storage capacity (K) as a measure of the amount of charge ($Q_R$) which can be drawn is determined using the formula:

$$K = K_{neu} * S_{neu}/S$$

where $K_{neu}$ is the storage capacity of the storage battery in the new state, $S_{neu}$ is the degree of change characteristic value and S is the present degree of change.

**12.** Method according to one of claims 9 to 11, **characterized by** the degrees of change (S) for a new storage battery being determined repeatedly over a defined time, and by a degree of change characteristic value ($S_{neu}$) being learnt from the determined degrees of change (S).

**13.** Method according to one of the preceding claims, **characterized by** the degrees of change (S) being determined for comparable states of charge and temperatures of the storage battery.

**14.** Method according to one of the preceding claims, **characterized by** the amount of charge ($Q_R$) which can be drawn being determined from the degree of change (S) using a function or a value table.

**15.** Method according to one of the preceding claims, **characterized by** the amount of charge ($Q_R$) which can be drawn being determined as a function of the temperature (T) of the storage battery.

**16.** Method according to Claim 15, **characterized by** the degrees of change (S) being normalized to a nominal temperature ($T_n$).

**17.** Method according to one of the preceding claims, **characterized in that** the magnitude of the current values (I) of the current stimulus corresponds at most to the 10-hour current, preferably at most to the 50-hour current, and particularly preferably to the 200-hour current.

**18.** Method according to one of the preceding claims, **characterized in that** a current change in the current stimulus is carried out with a current rate of change (dI/dt) whose magnitude is at least in the same order of magnitude as the quotient of the 5000-hour current per second, preferably at least in the same order of magnitude as the quotient of the 1000-hour current per second, and particularly preferably at least in the same order of magnitude as the quotient of the 200-hour current per second.

**19.** Method according to one of the preceding claims, **characterized in that** the degree of change (S) is determined only from that section of the response signal profile which was measured at the earliest one second after the stimulus, preferably 10 seconds after the stimulus, and at the latest 1000 seconds, and preferably at the latest 100 seconds, after the stimulus.

**20.** Method according to one of the preceding claims, **characterized in that** the only values of the response signal profile which are used for linearization are those which satisfy a defined certainty measure.

**21.** Method according to one of the preceding claims, **characterized by** a pulsed current stimulus (I(t)) being applied to the storage battery by means of an electrical switching unit.

**22.** Method according to one of the preceding claims, **characterized by** the determined amount of charge (QR) which can be drawn being linked to a present degree of discharge (DoD) and/or to a present state of charge (SOC), in order to determine the amount of charge ($Q_L$) with which the storage battery can be charged.

**23.** Method according to one of the preceding claims, **characterized by** comparison of the determined amount of charge (QR) which can be drawn, the degree of charge (S), the amount of charge ($Q_L$) with which the storage battery can be charged, and/or the energy storage capacity (K) of the storage battery as a comparison variable with a defined threshold value, and outputting of the discrepancy or of the ratio of the comparison variable to able to the threshold value.

**24.** Method according to Claim 23, **characterized in that** the threshold value is temperature-dependent.

**25.** Method according to one of the preceding claims, **characterized by** the present storage capacity of the storage battery being determined from the determined amount of charge (QR) which can be drawn, and by the present storage capacity being linked to the storage capacity of the storage battery in the new state in order to determine a measure for the reduction in the storage capacity.

**26.** Method according to Claim 25, **characterized by** comparison of the determined measure for the reduction in the storage capacity with a defined threshold value.

**27.** Monitoring device for a storage battery having measurement means for measurement of the battery voltage (U(t)) and/or battery currents (I(t)) over time in-

tervals ($\Delta$t), and having evaluation means, **characterized in that** the evaluation means are designed for carrying out the method according to one of the preceding claims.

**Revendications**

1. Procédé pour déterminer la charge disponible ($Q_R$) qui peut être prélevée d'une batterie d'accumulateurs, procédé comprenant les étapes suivantes :

   - exciter électriquement la batterie d'accumulateurs,
   - déterminer une courbe de signal de réponse en fonction du temps d'un signal de réponse de la batterie d'accumulateurs à l'excitation électrique au cours de l'intervalle de temps,
   - linéariser la courbe du signal de réponse,
   - déterminer le degré de variation (S) de la courbe du signal de réponse linéarisée dans l'intervalle de temps, et
   - déterminer la charge disponible ($Q_R$) qui peut être prélevée directement à partir du degré de variation (S).

2. Procédé selon la revendication 1,
   **caractérisé en ce que**
   la courbe du signal de réponse est une réponse en tension (M (t)) à une excitation impulsionnelle de courant (I (t)) de la batterie d'accumulateurs.

3. Procédé selon la revendication 1,
   **caractérisé en ce que**
   la courbe du signal de réponse est une réponse en intensité (I (t)) à une excitation en tension (U (t)) appliquée à la batterie d'accumulateurs.

4. Procédé selon l'une des revendications précédentes,
   **caractérisé en ce qu'**

   - on détermine une droite de compensation par la courbe du signal de réponse linéarisée, et
   - on détermine la pente ($S_i$) de la droite de compensation comme degré de variation.

5. Procédé selon la revendication 4,
   **caractérisé en ce que**
   la charge disponible ($Q_R$) qui peut être prélevée est inversement proportionnelle à la pente ($S_i$) de la droite de compensation.

6. Procédé selon l'une des revendications précédentes,
   **caractérisé en ce que**
   la linéarisation de la courbe du signal de réponse se fait par l'exploitation de la courbe du signal de réponse en fonction de la racine carrée de la différence de temps (t-$t_0$) entre l'instant initial ($t_0$) de l'intervalle de temps ($\Delta$t) et du temps (t).

7. Procédé selon l'une des revendications précédentes,
   **caractérisé en ce que**

   - on applique à la batterie d'accumulateurs une succession d'impulsions de courant ou de tension,
   - on détermine le degré de variation (S) respectif pour les courbes du signal de réponse aux différentes impulsions de courant ou de tension,
   - on détermine la charge disponible ($Q_R$) qui peut être prélevée en fonction de la droite de variation (S) déterminée.

8. Procédé selon l'une des revendications précédentes,
   **caractérisé en ce que**

   - on détermine de manière répétée la droite de variation (S) des courbes du signal de réponse, linéarisée pendant la durée d'utilisation de la batterie d'accumulateurs,
   - on détermine la variation relative de la charge disponible ($Q_R$) qui peut être prélevée en fonction de la variation relative du degré de variation (S), et
   - on détermine une mesure de l'usure de la batterie d'accumulateurs à partir de la variation relative.

9. Procédé selon l'une des revendications précédentes,
   **caractérisé en ce qu'**
   on détermine la charge disponible ($Q_R$) prélevable en fonction de la valeur du degré de variation ($S_{neu}$) caractéristique de l'état neuf de la batterie d'accumulateurs rapportée au degré de variation (S).

10. Procédé selon la revendication 9,
    **caractérisé en ce qu'**
    on détermine la charge disponible ($Q_R$) qui peut être prélevée en fonction de la capacité d'accumulation d'énergie actuelle (K),
    la capacité d'accumulation d'énergie actuelle (K) étant proportionnelle au rapport de la valeur caractéristique du degré de variation ($S_{neu}$) caractéristique de l'état neuf de la batterie d'accumulateurs par rapport à la pente ($S_i$) déterminée d'une courbe de signal de réponse, linéarisée.

11. Procédé selon la revendication 10,
    **caractérisé en ce qu'**
    on détermine la capacité d'accumulation d'énergie actuelle (K) comme mesure de la charge disponible

($Q_R$) prélevable selon la formule :

$$K = K_{neu} * S_{neu} / S$$

formule dans laquelle $K_{neu}$ est la capacité d'accumulation de la batterie d'accumulateurs à l'état neuf, $S_{neu}$ est la valeur caractéristique du degré de variation caractéristique et S est le degré de variation actuel.

**12.** Procédé selon l'une des revendications 9 à 11, **caractérisé en ce qu'** on détermine de manière répétée les droites de variation (S) pour une batterie d'accumulateurs neuve sur une durée déterminée et on apprend une valeur caractéristique de droite de variation ($S_{neu}$) caractéristique à partir des droites de variation (S), déterminées.

**13.** Procédé selon l'une des revendications précédentes, **caractérisé en ce qu'** on détermine la droite de variation (S) pour des états de charge et des températures comparables de la batterie d'accumulateurs.

**14.** Procédé selon l'une des revendications précédentes, **caractérisé en ce qu'** on détermine la charge disponible prélevable ($Q_R$) à partir du degré de variation (S) à l'aide d'une fonction ou d'un tableau de valeurs.

**15.** Procédé selon l'une des revendications précédentes, **caractérisé en ce qu'** on détermine la charge disponible prélevable ($Q_R$) en fonction de la température (T) de la batterie d'accumulateurs.

**16.** Procédé selon la revendication 15, **caractérisé en ce qu'** on normalise la droite de variation (S) par rapport à une température nominale ($T_n$).

**17.** Procédé selon l'une des revendications précédentes, **caractérisé en ce que** l'amplitude de l'intensité de courant (I) de l'excitation de courant, correspond au plus à un courant de 10 heures et de préférence à un courant au plus de 50 heures et d'une manière particulièrement préférentielle, à un courant de 200 heures.

**18.** Procédé selon l'une des revendications précédentes, **caractérisé en ce qu'** on modifie l'intensité de l'excitation du courant selon un degré de variation d'intensité (dI/Dt) dont l'amplitude est au moins de l'ordre de grandeur du quotient d'un courant de 5000 heures par seconde, de préférence au moins de l'ordre de grandeur du quotient du courant de 1000 heures par seconde et d'une manière particulièrement préférentielle, au moins de l'ordre de grandeur du quotient du courant de 200 heures par seconde.

**19.** Procédé selon l'une des revendications précédentes, **caractérisé en ce que** le degré de variation (S) est déterminé seulement à partir du segment de la courbe du signal de réponse qui a été mesurée au plut tôt une seconde et de préférence 10 secondes et au plus tard 1000 secondes et de préférence encore plus tard à 100 secondes après l'excitation.

**20.** Procédé selon l'une des revendications précédentes, **caractérisé en ce qu'** pour la linéarisation on utilise seulement les valeurs de la courbe du signal de réponse répondant à une mesure de détermination définie.

**21.** Procédé selon l'une des revendications précédentes, **caractérisé en ce qu'** on applique une excitation impulsionnelle de courant (I (t)) par une unité de commutation électrique à la batterie d'accumulateurs.

**22.** Procédé selon l'une des revendications précédentes, **caractérisé en ce qu'** on réunit la charge disponible ($Q_R$) prélevable à l'aide d'un degré de décharge actuel (DoD) et/ou d'un état de charge actuel (SoC) pour déterminer la charge ($Q_L$) que peut recevoir la batterie d'accumulateurs.

**23.** Procédé selon l'une des revendications précédentes, **caractérisé en ce que** on compare la charge disponible ($Q_R$) prélevable, déterminée, le degré de variation (S), la charge disponible ($Q_L$) et/ou la capacité d'accumulation d'énergie (K) de la batterie d'accumulateurs, comme grandeurs de référence, à une valeur de seuil définie et à l'émission de l'écart ou du rapport des grandeurs de comparaison à la valeur de seuil.

**24.** Procédé selon la revendication 23, **caractérisé en ce que**

la valeur du seuil dépend de la température.

**25.** Procédé selon l'une des revendications précédentes,
**caractérisé en ce qu'**
on détermine une mesure de la réduction de la capacité d'accumulation en déterminant la capacité d'accumulation actuelle de la batterie d'accumulateurs à partir de la quantité de charge ($Q_R$) déterminée, prélevable et en combinant la capacité de stockage actuelle à la capacité de stockage de la batterie d'accumulateurs à l'état neuf.

**26.** Procédé selon la revendication 25,
**caractérisé en ce qu'**
on compare la mesure obtenue pour la réduction de la capacité d'accumulation à une valeur de seuil définie.

**27.** Installation de surveillance pour une batterie d'accumulateurs équipée de moyens de mesure pour mesurer une tension de batterie (U (t)) et/ou un courant de batterie (I (t)) selon l'intervalle de temps (Δt) et avec des moyens d'exploitation,
**caractérisée en que**
les moyens d'exploitation sont réalisés pour exécuter le procédé selon l'une des revendications précédentes.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5761072 A
- DE 9321638
- US 5680050 A
- DE 69131276 T2
- EP 0516336 B1
- US 6118275 A